# EUROPÄISCHE PATENTSCHRIFT

(11) **EP 0 878 906 B1**
(45) Veröffentlichungstag und Bekanntmachung des Hinweises auf die Patenterteilung: **02.07.2003**
(21) Anmeldenummer: 98201373.2
(22) Anmeldetag: 28.04.1998
(51) Int. Cl.: H03J 1/00

(54) **Rundfunkempfänger**
Radio receiver
Récepteur de radio

(30) Priorität: 13.05.1997 DE 19719912
(43) Veröffentlichungstag der Anmeldung: 18.11.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: Völkel, Andreas, Röntgenstrasse 24, 22335 Hamburg (DE)
(74) Vertreter: Poddig, Dieter, Dipl.-Ing.

(56) Entgegenhaltungen:
- EP-A- 0 095 564
- EP-A- 0 259 970
- DE-A- 3 236 696

## Beschreibung

Die Erfindung bezieht sich auf einen Rundfunkempfänger, insbesondere UKW-Empfänger, mit
- einer Empfangsstufe zum Empfangen und Demodulieren eines Rundfunksignals,
- einer Auswertestufe zum Auswerten der Empfangsqualität empfangener Rundfunksignale nach vorgegebenen Empfangskriterien,
- einer Speicherstufe zum Speichern von Daten über zumindest Sendefrequenzen und/oder Sendernamen von Sendern, deren Rundfunksignale die vorgegebenen Empfangskriterien erfüllen,
- einem Bedienelement zum Einstellen der Empfangsstufe auf den Empfang des Rundfunksignals eines gewünschten Senders,
- einem Anzeigeelement zum Anzeigen einer aus den gespeicherten Daten abgeleiteten Information über wenigstens den gewünschten Sender, und
- einer Steuereinheit zum Steuern wenigstens der Empfangsstufe, der Speicherstufe und des Anzeigeelements nach Maßgabe der Betätigung des Bedienelements und der von der Auswertestufe ausgewerteten Empfangsqualität.

Aus der EP-A-95 564 ist ein ortsveränderlicher Rundfunkempfänger, insbesondere ein Autoradio mit Programm-Direktwahl bekannt, der in einem Bedienfeld Programmanzeigeflächen und diesen zugeordnete Wahltasten zum Anwählen der angezeigten Programme aufweist. Zur Schaffung eines kleinen überschaubaren Bedienfeldes, in welchem dennoch eine Mehrzahl von an verschiedenen Standorten des Rundfunkempfängers empfangbaren Sendeprogrammen angezeigt wird, sind die Programmanzeigeflächen mit austauschbaren Programmanzeigen belegbar, die eine aktuelle Auswahl derjenigen Programme wiedergeben, die von Sendern abgestrahlt werden, deren Empfangsqualität am momentanen Empfängerstandort vorgegebenen Empfangskriterien, z.B. einer vorbestimmten Empfangsfeldstärke, genügt.

Dieser bekannte Rundfunkempfänger enthält einen Koppelspeicher mit wahlfreiem Zugriff (RAM), der eine Anzahl von Speicherplätzen aufweist, von denen jeder einer der Programmanzeigeflächen mit zugeordneter Wahltaste fest zugeordnet ist. Dieser Koppelspeicher wird mit Senderbestimmungsgrößen der am Empfängerort empfangbaren Sender, die dem vorbestimmten Empfangskriterium genügen, belegt. Diese Belegung wird laufend aktualisiert. Für die laufende Aktualisierung des Speicherinhalts in Anpassung an einen wechselnden Empfängerort ist bei dem bekannten Rundfunkempfänger eine Schaltung erforderlich, deren wesentliche Komponenten ein zweiter Empfangsteil mit Suchlaufautomatik zum permanenten Aufsuchen empfangbarer Sender, eine Senderidentifikationsvorrichtung zum Identifizieren des jeweils aufgefundenen Senders und eine Empfangsqualitäts-Kontrollvorrichtung zum Prüfen der Empfangsqualität des jeweils aufgefundenen Senders sind. Diese Komponenten sind im bekannten Rundfunkempfänger zusätzlich zu dem für den Empfang und die Wiedergabe der gewünschten Programme erforderlichen Empfangsteil vorhanden.

Aus der GB-A-2 213 336 ist ein RDS-Rundfunkempfänger mit Anzeige wahlweiser Sendefrequenzen bestimmter Sendestationen bekannt. Dieser Rundfunkempfänger enthält eine Abstimmstufe, die wenigstens über zwei Frequenzbänder abstimmbar ist. Mit ihr ist ein Datendekoder verbunden zum Dekodieren von Datensignalen, die zusammen mit einem empfangenen Rundfunksignal übertragen worden sind. Dabei befindet sich das empfangene Rundfunksignal innerhalb eines ersten Frequenzbandes, beispielsweise im Mittelwellenbereich. Die Datensignale umfassen Daten, die sich auf Rundfunksignale innerhalb des ersten Frequenzbandes beziehen, und solche, die sich auf Rundfunksignale in den anderen Frequenzbändern beziehen, beispielsweise dem Langwellenbereich. Mit dem Datendekoder ist ein Datenspeicher verbunden zum Speichern der Datensignale, die sich auf die anderen Frequenzbänder beziehen. Über eine berührungsempfindliche Anzeigeeinheit werden die Daten, die zu einem ausgewählten Rundfunksignal gehören, zumindest teilweise wiedergegeben. Auf diese Weise werden mit der Empfangsanordnung RDS-Daten festgehalten, die bei Sendefrequenzen übertragen werden, auf die das RDS-System angewendet wird und die sich auf Sendefrequenzen insbesondere für dasselbe Rundfunkprogramm beziehen, bei denen kein RDS-Signal übertragen wird. Auf diese Weise kann die Auswahl aller oder zumindest eines Teils der Sendefrequenzen zu einem Rundfunkprogramm auf der Anzeige dargestellt und kann die gewünschte Sendefrequenz zu dem gewünschten Rundfunkprogramm ausgewählt werden.

Die Rundfunkempfänger nach dem Stand der Technik sind einerseits verhältnismäßig aufwendig konstruiert und/oder andererseits nur eingeschränkt einsetzbar. So bedeutet der Einsatz zweier parallel arbeitender, vollständiger Empfangsteile (Tuner), von denen während eines überwiegenden Teils der Betriebsdauer des Rundfunkempfängers nur eines benötigt wird, gerade bei einem in hohen Stückzahlen gefertigten Konsumartikel, wie dies ein Rundfunkempfänger darstellt, einen sehr hohen und unwirtschaftlichen Mehraufwand. Andererseits sind auch die beschriebenen Anzeigeeinrichtungen sehr aufwendig und benötigen vor allem sehr viel Platz gerade auf der Vorderseite der Rundfunkgeräte, auf der in der Regel sämtliche Bedienorgane eines solchen Rundfunkempfängers angeordnet sind. Insbesondere bei Rundfunkempfängern zum Einsatz in Kraftfahrzeugen, wo die Abmessungen der Vorderseiten der Rundfunkempfänger durch die genormten Aufnahmeschächte eng begrenzt sind, bereitet jedes ausgedehnte Bedienungsorgan große konstruktive Schwierigkeiten. Außerdem steigt mit zunehmender Anzahl der Bedienungsorgane auch der Grad der Kompliziertheit der Handhabung durch den Rundfunkhörer. Andererseits nimmt auch bei anderweitig einzusetzenden Rundfunkempfängern aufgrund der Miniaturisierung der Bauteile das Verhältnis des Platzbedarfs der Bedienungsorgane zum Platzbedarf der sonstigen. Elemente zu, so daß eine Vereinfachung der Bedienungsorgane ohne Einbußen der Bedienungsfreundlichkeit bei zunehmender Anzahl von Leistungsmerkmalen solcher Rundfunkempfänger dringend erforderlich ist.

Die Erfindung hat die Aufgabe, einen Rundfunkempfänger der eingangs genannten Art so auszubilden, daß eine einfache, platzsparende und übersichtliche Auswahl der gewünschten Sender bei geringem apparativem Aufwand ermöglicht wird.

Erfindungsgemäß wird diese Aufgabe bei einem Rundfunkempfänger der eingangs genannten Art dadurch gelöst, daß zum Einstellen der Empfangsstufe auf den gewünschten Sender die Daten der Sender, deren Rundfunksignale die vorgegebenen Empfangskriterien erfüllen, in einer von der Steuereinheit bestimmten, nach wählbaren Merkmalen sortierten Reihenfolge durch Betätigen des Bedienelements aus der Speicherstufe auslesbar sind, wobei das Bedienelement mit einem einzigen Anwahlglied ausgebildet ist, durch welches von einem gewünschten Sender auf jeweils den vorigen oder den nächsten Sender in der bestimmten Reihenfolge weitergestellt werden kann, und daß die in der Speicherstufe gespeicherten Daten unter wahlweise einer der folgenden Voraussetzungen wenigstens teilweise zu Daten solcher Sender aktualisiert werden, deren Rundfunksignale augenblicklich die vorgegebenen Empfangskriterien erfüllen:
- wenn die Empfangsqualität des Rundfunksignals eines gewünschten Senders die vorgegebenen Empfangskriterien augenblicklich nicht bzw. nicht mehr erfüllt, werden die zugehörigen Daten in der Speicherstufe gelöscht und wird die Empfangsstufe auf den Empfang des Rundfunksignals eines neuen gewünschten Senders eingestellt; vorzugsweise weist der neue gewünschte Sender dasselbe Programm wie der bisherige gewünschte Sender auf, und die Daten des neuen gewünschten Senders treten in der Speicherstufe an die Stelle der gelöschten Daten des bisherigen gewünschten Senders; besonders vorzugsweise wird der neue gewünschte Sender durch einen Sendersuchlauf der Empfangsstufe gefunden;
- wenn durch Betätigen des Bedienelements der gewünschte Sender gewechselt wird, wird geprüft, ob das Rundfunksignal des neuen gewünschten Senders die vorgegebenen Empfangskriterien erfüllt; trifft das zu, werden die Daten in der Speicherstufe von der Steuereinheit um die Daten des neuen gewünschten Senders ergänzt; vorzugsweise wird dabei die Sendefrequenz des neuen gewünschten Senders durch einen Sendersuchlauf der Empfangsstufe gefunden;
- bevor zumindest die Empfangsstufe des Rundfunkempfängers abgeschaltet wird, werden von der Steuereinheit durch einen Sendersuchlauf für einen möglichst umfangreichen Sendefrequenzbereich, vorzugsweise für alle Sendefrequenzen, auf die die Empfangsstufe einstellbar ist, die Daten der Sender, deren Rundfunksignale die vorgegebenen Empfangskriterien erfüllen, neu in der Speicherstufe gespeichert;
wobei die Daten der Sender aus einer Bestimmung der Sendefrequenzen der empfangenen Rundfunksignale und/oder aus einem als Teil der Rundfunksignale empfangenen RDS-Datenstrom gewonnen werden.

In der Terminologie der vorliegenden Erfindung ist mit dem Begriff "Sender" ein Signal umschrieben, welches - auf eine Sendefrequenz bzw. Trägerfrequenz aufmodulierte Rundfunksignale, insbesondere Tonsignale, sowie gegebenenfalls Datensignale umfaßt und von einer Rundfunkstation über eine Sendeanlage an einem gegebenen Ort ausgestrahlt wird. Mit "Programm" ist das Rundfunksignal mit einem bestimmten Informationsgehalt bezeichnet. Ein Programm, in der Bundesrepublik Deutschland beispielsweise als "NDR1", "WDR1", "SFB" usw. ausgestrahlt, kann über mehrere Sendeanlagen auf unterschiedliche Sendefrequenzen (Trägerfrequenzen) aufmoduliert an verschiedenen Orten abgestrahlt werden.

Mit "Sendersuchlauf" ist hier das (automatische) Durchstimmen der Empfangsstufe, insbesondere mit Hilfe der Steuereinheit, bezeichnet, welches so lange fortgeführt wird, bis ein Rundfunksignal bzw. ein Sender empfangen wird. Das Abschalten des Rundfunkempfängers bzw. zumindest seiner Empfangsstufe bewirkt bei dem Gegenstand der vorliegenden Erfindung die Außerbetriebnahme des gesamten Rundfunkempfängers oder lediglich die Außenbetriebnahme der Empfangsstufe, wobei beispielsweise vom Rundfunkempfänger umfaßte Tonwiedergabevorrichtungen, insbesondere Lautsprecher, zur Wiedergabe von Tonsignalen aus anderen Klangquellen weiterhin genutzt werden können, beispielsweise zur Wiedergabe von Tonsignalen auf Tonbandkassetten oder CDs. In jedem dieser Fälle wird jedoch die Empfangsstufe des Rundfunkempfängers nach dem Abschalten nicht mehr für eine Klangwiedergabe der Tonsignale eines Senders bzw. eines Programms benötigt.

Die Erfindung hat den Vorteil, daß ein Rundfunkempfänger geschaffen wird, der einerseits einfach aufgebaut ist und andererseits einfache, platzsparende und übersichtliche Bedienungsorgane aufweist. Vorteilhaft können dabei wenigstens die Auswertestufe und die Steuereinheit in einem Mikroprozessor zusammengefaßt sein. Über dessen Programmierung läßt sich eine sehr leistungsfähige und flexible Organisation der Daten in der Speicherstufe erreichen.

Das Anwahlglied kann als Suchlauftaste ausgebildet sein, ist aber bevorzugt in der Art eines Senderwahl-Drehknopfes ausgebildet. Dies ermöglicht die Bedienung zur Auswahl des gewünschten Senders in einer ergonomisch günstigen Weise. Das Bedienelement umfaßt dazu einen mit dem Anwahlglied gekoppelten Inkrementgeber zum Weiterstellen zu dem in der bestimmten Reihenfolge jeweils benachbarten Sender. Dabei kann ein bestimmter Drehwinkel des Senderwahl-Drehknopfes entweder grundsätzlich der Weiterschaltung von einem Sender zum nächsten bzw. vorherigen Sender dienen; andererseits kann ein vorgegebener Drehwinkel auch einem bestimmten Frequenzabstand auf der Skala der Sendefrequenzen entsprechen, was durch geeignete Ausbildung des Inkrementgebers oder geeignete Gestaltung der Verarbeitungsschritte für vom Inkrementgeber gelieferte Signale sehr einfach gewählt werden kann. Auch diese Wahl dient der Ergonomie des Bedienelements.

Zur Bestimmung der Reihenfolge für das Auslesen der Daten aus der Speicherstufe können verschiedene Merkmale der aufgefundenen Sender wahlweise herangezogen werden. Beispielsweise kann dazu die Sendefrequenz ausgewählt werden, und beim Betätigen des Bedienelements werden die in der Speicherstufe gespeicherten Sender in der Reihe ihrer Sendefrequenzen eingestellt. Ebenso einfach ist auch eine alphabetisch bestimmte Reihenfolge der Sender nach den Sendernamen möglich, wodurch dem Rundfunkhörer die Auswahl der Sender nach einem gesuchten Programm erleichtert wird. Möchte also der Rundfunkhörer ein bestimmtes Programm empfangen, kann er dessen Sendernamen (bzw. auch als Namen des Programms bezeichnet) über das Bedienelement unmittelbar einstellen, ohne die Frequenzskala absuchen bzw. durchlaufen zu müssen und ohne sich die Zuordnung der Sendernamen zur Frequenzskala zu vergegenwärtigen.

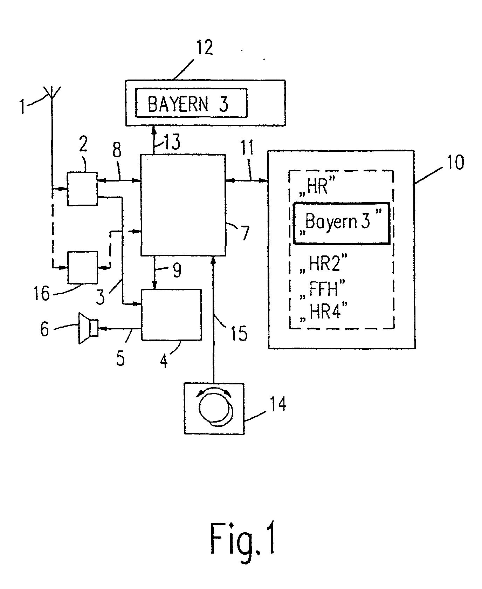

Die Zeichnung zeigt ein Ausführungsbeispiel eines erfindungsgemäßen Rundfunkempfängers.
Darin ist in Fig. 1 ein Blockdiagramm des Rundfunkempfängers dargestellt,
Fig. 2 zeigt als stark vereinfachtes Beispiel eine Liste von Sendern, deren Empfangsqualität vorgegebene Empfangskriterien erfüllt, und
Fig. 3 zeigt eine symbolische, alphabetische Sortierung der Sendernamen mit Zuordnung zum Bedienelement.

Fig. 1 zeigt ein grob schematisches Blockschaltbild eines erfindungsgemäßen Rundfunkempfängers. Über eine Antenne 1 gelangen zu empfangende Rundfunksignale an eine Empfangsstufe 2, in der sie in üblicher Weise demoduliert werden. Die daraus gewonnenen, niederfrequenten Tonsignale werden über eine Leitung 3 einem Tonsignalverstärker 4 zugeführt, darin verstärkt und zur Wiedergabe über eine Lautsprecherleitung 5 einem Lautsprecher 6 zugeführt. Diese Bestandteile des Rundfunkempfängers von der Antenne 1 bis zum Lautsprecher 6 sind in an sich üblicher Weise ausgebildet.

Der Rundfunkempfänger nach Fig. 1 enthält weiterhin eine Steuereinheit 7, die vorzugsweise mit einem Mikroprozessor ausgebildet ist und die über Signal- bzw. Steuerleitungen 8, 9 mit der Empfangsstufe 2 bzw. dem Verstärker 4 verbunden ist. Mit dem Steuereinheit 7 ist ferner eine Speicherstufe 10 über eine Datenleitung 11, ein Anzeigeelement 12 über eine Leitung 13 und ein Bedienelement 14 über eine Steuerleitung 15 verbunden. Im vorliegenden Beispiel umfaßt die mit einem Mikroprozessor ausgebildete Steuereinheit 7 auch eine Auswertestufe zum Auswerten der Empfangsqualität der von der Empfangsstufe 2 über die Antenne 1 empfangenen Rundfunksignale nach vorgegebenen Empfangskriterien, beispielsweise der Empfangsfeldstärke. Der Mikroprozessor übernimmt in diesem Fall somit die Funktion der Auswertestufe, der Steuereinheit für die erfindungsgemäßen Steuervorgänge sowie darüber hinaus auch die Steuerung des Daten- und Signalflusses in und zwischen den übrigen Bauteilen des dargestellten Rundfunkempfängers. Da in modernen Rundfunkempfängern beispielsweise für Sendersuchlauf und Einstellung der Tonwiedergabeparameter (Lautstärke, Klangfarbe, Balance zwischen mehreren Lautsprechern, Umschalten zwischen verschiedenen Tonsignalquellen, usw.) ohnehin eine Mikroprozessorsteuerung vorgesehen wird, kann diese in einfacher Weise auch für die erfindungsgemäße Ausbildung des Rundfunkempfängers herangezogen werden, ohne daß ein nennenswerter konstruktiver Mehraufwand nötig ist. Dadurch werden die Vorteile der Erfindung, die Vereinfachung der Anzeige- und Bedienelemente, in besonderer Weise zur Geltung gebracht.

Beim erfindungsgemäßen Rundfunkempfänger wird ein an sich bekannter Sendersuchlauf, bei dem die Empfangsstufe 2 mit Hilfe der Steuereinheit 7 durchgestimmt wird, in an sich bekannter Weise dazu benutzt, die Rundfunksignale der zu empfangenden Sender, insbesondere eines gewünschten Senders, im von der Empfangsstufe 2 abgedeckten Frequenzbereich (Wellenbereich) aufzufinden. Die Rundfunksignale eines aufgefundenen Senders werden durch die Auswertestufe, also vom Mikroprozessor der Steuereinheit 7 auf die Erfüllung vorgegebener Empfangskriterien hin überprüft. Insbesondere wird dabei überprüft, ob die Empfangsfeldstärke einen vorgegebenen Grenzwert nicht unterschreitet. Es können jedoch auch andere Empfangskriterien geprüft werden, beispielsweise der Klirrfaktor oder die Amplitude bestimmter Daten- oder Kennsignale im Rundfunksignal, wie beispielsweise des Stereo-Kennsignals. Erfüllt das empfangene Rundfunksignal die vorbestimmten Empfangskriterien, wird mit allen aus diesem Rundfunksignal entnehmbaren Daten in der Speicherstufe 10 eine Datenbank eingerichtet bzw. aktualisiert. Dazu wird in der Speicherstufe 10 insbesondere die detektierte Sendefrequenz des Senders, auf den die Empfangsstufe 2 gerade eingestellt ist, abgespeichert. Zusätzlich können im Rundfunksignal bevorzugt RDS-Datensignale enthalten sein, die weitere Informationen über den gerade eingestellten Sender enthalten. Auch diese Daten werden in der Speicherstufe 10 abgespeichert. Die gespeicherten Daten bilden auf diese Weise - über den Sendersuchlauf im gesamten Frequenzbereich gesammelt - eine Datenbank der augenblicklich mit einer Empfangsqualität zu empfangenden Sender, die den vorgegebenen Empfangskriterien genügt. Zusätzlich erlaubt die Auswertung von RDS-Daten die Speicherung von Daten über weitere Sender, und es in einer Ausgestaltung des erfindungsgemäßen Rundfunkempfängers möglich, daß die Empfangsstufe 2 von der Steuereinheit 7 auch auf diese zusätzlichen Sender abgestimmt wird, um zu detektieren, ob diese Sender ebenfalls die vorgegebenen Empfangskriterien erfüllen.

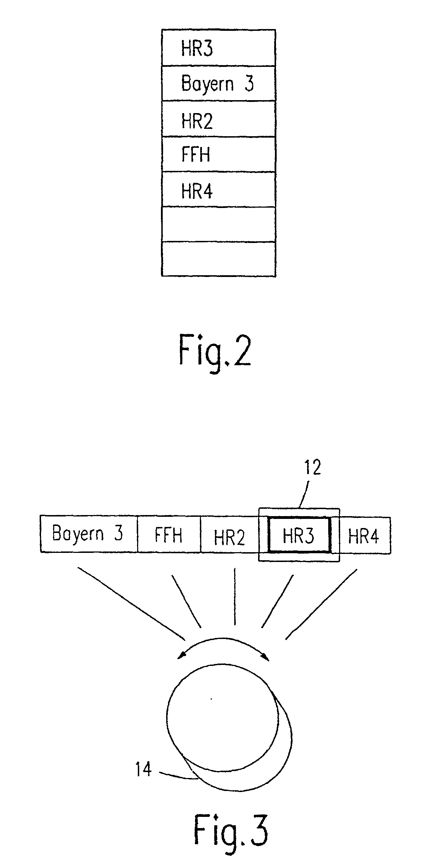

Die in der Speicherstufe 10 abgespeicherte Datenbank der mit hinreichender Empfangsqualität zu empfangenden Sender steht dem Benutzer des Rundfunkempfängers (Rundfunkhörer) zur Auswahl über das Bedienelement 14 zur Verfügung. Fig. 2 zeigt ein sehr einfaches Beispiel mit einer grob schematischen Darstellung der Eintragung von fünf verschiedenen Sendern in einer Liste, die eine Datenbank zu empfangender Sender in der Speicherstufe 10 bildet. Diese Datenbank enthält die Daten der Sender zunächst ungeordnet, wie sie beim Sendersuchlauf gefunden und abgespeichert werden. Eine von der Steuereinheit 7 zur Verwaltung der Speicherstufe 10 ohnehin benötigte Funktion des Mikroprozessors erlaubt es nun, diese zunächst ungeordnete Datenbank nach verschiedenen, wählbaren Kriterien zu sortieren. Demzufolge ist es in einfacher Weise möglich, dem Rundfunkhörer beim Betätigen des Bedienelements die Sender, die die Empfangskriterien- erfüllen (Sender hinreichender Empfangsqualität), beispielsweise alphabetisch zur Verfügung zu stellen. Durch Betätigen des Bedienelements 14 können somit die einzelnen Sender in einer Reihenfolge angewählt werden, wie dies durch Fig. 3 schematisch dargestellt ist. Beim Drehen des als Senderwahl-Drehknopf ausgebildeten Anwahlgliedes des Bedienelements 14 wird zwischen den Sendern in der alphabetischen Reihenfolge ihrer Sendernamen umgeschaltet und der jeweils ausgewählte, d.h. gewünschte Sender wird - gesteuert durch die Steuereinheit 7 über die Leitung 13 - vom Anzeigeelement 12 mit Namen angezeigt. Im Beispiel nach Fig. 1 is dies der Sender "Bayern 3", im Beispiel nach Fig. 3 ist es der Sender "HR3".

Eine andere Sortiermöglichkeit bietet sich in Anlehnung an die konventionelle Frequenzskala der Senderabstimmung dadurch an, daß die Datenbank in der Speicherstufe 10 aufsteigend nach Sendefrequenzen der Sender hinreichender Empfangsqualität sortiert und angeboten wird. Mit dem Bedienelement 14 kann dann eine Anwahl der einzelnen Sender, d.h. eine Auswahl des gewünschten Senders, wie auf der konventionellen Frequenzskala (Abstimmskala eines konventionellen Rundfunkempfängers) erfolgen.

Insbesondere bei einem mobilen Einsatz des erfindungsgemäßen Rundfunkempfängers ist es wichtig, die Datenbank in der Speicherstufe 10 regelmäßig zu aktualisieren, da sich die örtlichen Empfangsbedingungen und damit die Empfangsqualität der einzelnen Sender oft sehr stark ändern können. Eine Aktualisierung der Datenbank wird beim erfindungsgemäßen Rundfunkempfänger durch die Steuereinheit 7 bei jeder Gelegenheit durchgeführt, bei der die Empfangsstufe 2 nicht kontinuierlich zum Empfang eines gerade wiederzugebenden Rundfunksignals benötigt wird, oder auch während einer solchen Wiedergabe durch Auswertung des RDS-Datensignals. So wird in der Steuereinheit 7 von der darin umfaßten Auswertestufe die Empfangsqualität des gewünschten, gerade wiedergegebenen Senders laufend überwacht. Erfüllt diese die vorgegebenen Empfangskriterien nicht oder nicht mehr, d.h. wird der Empfang des gewünschten Senders qualitativ schlecht, werden die zugehörigen Daten in der Speicherstufe 10 gelöscht und wird die Empfangsstufe auf den Empfang des Rundfunksignals eines neuen gewünschten Senders eingestellt. Vorzugsweise weist der neue gewünschte Sender dasselbe Programm wie der bisherige gewünschte Sender auf, und die Daten des neuen gewünschten Senders treten in der Speicherstufe 10 an die Stelle der gelöschten Daten des bisherigen gewünschten Senders. Die Daten des neuen gewünschten Senders können dabei entweder durch einen Sendersuchlauf der Empfangsstufe 2 neu detektiert werden; es ist jedoch auch möglich, daß in der Speicherstufe 10 aus der Auswertung von RDS-Datensignalen bereits Daten über verschiedene Sender mit demselben Programm gespeichert sind und diese von der Steuereinheit 7 nacheinander aufgerufen werden, auf ihre Empfangsqualität hin überprüft werden und bei deren Erfüllung der dadurch gefundene Sender als neuer gewünschter Sender eingestellt und sein Programm wiedergegeben wird.

Eine andere Gelegenheit zur Aktualisierung der Datenbank in der Speicherstufe 10 bietet sich bei einem durch den Rundfunkhörer über das Bedienelement 14 ausgelösten Wechsel des Senders, wobei sowohl ein Wechsel zu einem anderen Sender mit demselben Programm wie auch zu einem Sender mit anderem Programm umfaßt ist. Die Überprüfung der Empfangskriterien des neuen gewünschten Senders führt selbsttätig zu einer Aktualisierung der Datenbank.

Ist der erfindungsgemäße Rundfunkempfänger außer mit der Empfangsstufe 2 auch noch mit weiteren - in Fig. 1 der Einfachheit halber nicht dargestellten - Tonsignalquellen verbunden bzw. ausgestattet, wird die Steuereinheit 7 immer dann, wenn ein Tonsignal von einer solchen anderen Tonsignalquelle (Kassettenrekorder, CD, ...) wiedergegeben wird, eine möglichst vollständige Aktualisierung der Datenbank in der Speicherstufe 10 vornehmen. Dabei wird sowohl ein Sendersuchlauf als auch die Auswertung von RDS-Datensignalen ausgenutzt. Derselbe Vorgang ist bevorzugt auch beim Außerbetriebsetzen des Rundfunkempfängers durch den Rundfunkhörer möglich. Die Steuereinheit 7 führt dann - für den Rundfunkhörer bevorzugt unbemerkt - eine vollständige Aktualisierung der Datenbank in der Speicherstufe 10 über den gesamten empfangbaren Frequenzbereich durch. Dies hat zusätzlich den Vorteil, daß bei Wiederinbetriebnahme des Rundfunkempfängers auf eine Datenbank mit größtmöglicher Aktualität zugegriffen werden kann.

Die Ausbildung des Anwahlgliedes des Bedienelementes 14 als Senderwahl-Drehknopf ermöglicht eine ergonomisch günstige Bedienung des erfindungsgemäßen Rundfunkempfängers. Durch die Drehbetätigung dieses Anwahlgliedes kann sehr günstig sowohl von einem Sender zum benachbarten Sender als auch in großen Stellschritten über die gesamte Liste der Sender aus der Datenbank hinweg eine Auswahl und Einstellung des gewünschten Senders vorgenommen werden. Schwierigkeiten aufgrund in dieser Einstellbewegung zu dicht benachbarter Sender treten dabei nicht auf.

Das Ausführungsbeispiel nach Fig. 1 zeigt gestrichelt eine Hilfs-Empfangsstufe 16, die erfindungsgemäß nicht nötig ist, jedoch auch beim erfindungsgemäßen Rundfunkempfänger eingesetzt werden kann. Wird die Aktualisierung der Datenbank in der Speicherstufe 10 über eine solche Hilfs-Empfangsstufe 16 - gesteuert durch die Steuereinheit 7 - vorgenommen, vereinfacht dies zwar die von der Steuereinheit 7 auszuführenden Funktionsschritte, dafür ist jedoch ein erhöhter Konstruktionsaufwand in Kauf zu nehmen.

## Patentansprüche

1. Rundfunkempfänger, insbesondere UKW-Empfänger, mit
- einer Empfangsstufe zum Empfangen und Demodulieren eines Rundfunksignals,
- einer Auswertestufe zum Auswerten der Empfangsqualität empfangener Rundfunksignale nach vorgegebenen Empfangskriterien,
- einer Speicherstufe zum Speichern von Daten über zumindest Sendefrequenzen und/oder Sendernamen von Sendern, deren Rundfunksignale die vorgegebenen Empfangskriterien erfüllen,
- einem Bedienelement zum Einstellen der Empfangsstufe auf den Empfang des Rundfunksignals eines gewünschten Senders,
- einem Anzeigeelement zum Anzeigen einer aus den gespeicherten Daten abgeleiteten Information über wenigstens den gewünschten Sender, und
- einer Steuereinheit zum Steuern wenigstens der Empfangsstufe, der Speicherstufe und des Anzeigeelements nach Maßgabe der Betätigung des Bedienelements und der von der Auswertestufe ausgewerteten Empfangsqualität,
**dadurch gekennzeichnet, daß** zum Einstellen der Empfangsstufe auf den gewünschten Sender die Daten der Sender, deren Rundfunksignale die vorgegebenen Empfangskriterien erfüllen, in einer von der Steuereinheit bestimmten, nach wählbaren Merkmalen sortierten Reihenfolge durch Betätigen des Bedienelements aus der Speicherstufe auslesbar sind, wobei das Bedienelement mit einem einzigen Anwahlglied ausgebildet ist, durch welches von einem gewünschten Sender auf jeweils den vorigen oder den nächsten Sender in der bestimmten Reihenfolge weitergestellt werden kann, und daß die in der Speicherstufe gespeicherten Daten unter wahlweise einer der folgenden Voraussetzungen wenigstens teilweise zu Daten solcher Sender aktualisiert werden, deren Rundfunksignale augenblicklich die vorgegebenen Empfangskriterien erfüllen:
- wenn die Empfangsqualität des Rundfunksignals eines gewünschten Senders die vorgegebenen Empfangskriterien augenblicklich nicht bzw. nicht mehr erfüllt, werden die zugehörigen Daten in der Speicherstufe gelöscht und wird die Empfangsstufe auf den Empfang des Rundfunksignals eines neuen gewünschten Senders eingestellt; vorzugsweise weist der neue gewünschte Sender dasselbe Programm wie der bisherige gewünschte Sender auf, und die Daten des neuen gewünschten Senders treten in der Speicherstufe an die Stelle der gelöschten Daten des bisherigen gewünschten Senders; besonders vorzugsweise wird der neue gewünschte Sender durch einen Sendersuchlauf der Empfangsstufe gefunden;
- wenn durch Betätigen des Bedienelements der gewünschte Sender gewechselt wird, wird geprüft, ob das Rundfunksignal des neuen gewünschten Senders die vorgegebenen Empfangskriterien erfüllt; trifft das zu, werden die Daten in der Speicherstufe von der Steuereinheit um die Daten des neuen gewünschten Senders ergänzt; vorzugsweise wird dabei die Sendefrequenz des neuen gewünschten Senders durch einen Sendersuchlauf der Empfangsstufe gefunden;
- bevor zumindest die Empfangsstufe des Rundfunkempfängers abgeschaltet wird, werden von der Steuereinheit durch einen Sendersuchlauf für einen möglichst umfangreichen Sendefrequenzbereich, vorzugsweise für alle Sendefrequenzen, auf die die Empfangsstufe einstellbar ist, die Daten der Sender, deren Rundfunksignale die vorgegebenen Empfangskriterien erfüllen, neu in der Speicherstufe gespeichert;
wobei die Daten der Sender aus einer Bestimmung der Sendefrequenzen der empfangenen Rundfunksignale und/oder aus einem als Teil der Rundfunksignale empfangenen RDS-Datenstrom gewonnen werden.

2. Rundfunkempfänger nach Anspruch 1, **dadurch gekennzeichnet, daß** wenigstens die Auswertestufe und die Steuereinheit in einem Mikroprozessor zusammengefaßt sind.

3. Rundfunkempfänger nach Anspruch 1,
**dadurch gekennzeichnet, daß** das Anwahlglied in der Art eines Senderwahl-Drehknopfes ausgebildet ist und das Bedienelement einen mit dem Anwahlglied gekoppelten Inkrementgeber umfaßt zum Weiterstellen zu dem in der bestimmten Reihenfolge jeweils benachbarten Sender.

4. Rundfunkempfänger nach Anspruch 1,
**dadurch gekennzeichnet, daß** als Merkmal der für das Auslesen der Daten aus der Speicherstufe bestimmten Reihenfolge die Sendefrequenz ausgewählt wird.

5. Rundfunkempfänger nach Anspruch 1,
**dadurch gekennzeichnet, daß** als Merkmal der für das Auslesen der Daten aus der Speicherstufe bestimmten Reihenfolge die Sendernamen, vorzugsweise alphabetisch, ausgewählt werden.

## Claims

1. A radio receiver, in particular a VHF receiver, comprising
- a receiver stage for receiving and demodulating a radio signal,
- an evaluation stage for evaluating the quality of the received radio signals in accordance with predetermined receiving criteria,
- a storage stage for storing data about at least transmitter frequencies and/or transmitter names of stations whose radio signals meet said predetermined receiving criteria,
- an operating element for setting the receiver stage so as to receive the radio signal of a desired station,
- a display element for displaying information about at least the desired station, which information is derived from the stored data, and
- a control unit for controlling at least the receiver stage, the storage stage and the display element according to the operation of the operating element, and for controlling the receiving quality evaluated by the evaluation stage,
**characterized in that** for tuning the receiver stage into the desired station, the data of the stations whose radio signals meet the predetermined receiving criteria can be read from the memory stage, in a sequence determined by the control unit in accordance with selectable characteristics, by operating the operating element, said operating element comprising a single selection member enabling switching from a desired station to the previous or subsequent station in accordance with said sequence, and **in that** the data stored in the memory stage are at least partly updated, under any one of the following freely selectable conditions, to form data of stations whose radio signals directly meet the predetermined receiving criteria:
- when the receiving quality of the radio signal of a desired station currently does not, or no longer, meets the predetermined receiving criteria, the relevant data in the memory stage are erased and the receiver stage is tuned to receive the radio signal of a new, desired station; preferably, the new, desired station broadcasts the same program as the hitherto desired station, and the data of the new, desired station replace the erased data of the hitherto desired station in the memory stage; it is particularly preferred that the new, desired station is found by autoscanning of the receiver stage;
- when the desired station is replaced by a new, desired station by operating the operating element, it is checked whether the radio signal of the new, desired station meets the predetermined receiving criteria; if so, the data in the memory stage of the control unit are replaced by the data of the new, desired station; preferably, the transmission frequency of the new desired station is found by autoscanning of the receiver stage;
- before at least the receiver stage of the radio receiver is turned off, the data of the stations having radio signals which meet the predetermined receiving criteria are stored again in the memory stage by the control unit by means of an autoscanning operation for a frequency range which is as wide as possible, preferably all frequencies to which the receiver stage can be tuned;
whereby the data of the stations are gained from the determination of the transmission frequencies of the received radio signals and/or from an RDS data flow received as a part of the radio signals.

2. A radio receiver as claimed in claim 1, **characterized in that** at least the evaluation stage and the control unit are comprised in a microprocessor.

3. A radio receiver as claimed in claim 1, **characterized in that** the selection member takes the form of a station-tuning knob, and the operating element comprises an incrementing means coupled to the selection member, which incrementor serves to switch to a station which, in the specific sequence, is an adjacent station.

4. A radio receiver as claimed in claim 1, **characterized in that** the transmission frequency is selected to define the specific sequence in which the data are read from the memory stage.

5. A radio receiver as claimed in claim 1, **characterized in that** the, preferably alphabetical, station names are used to define the specific sequence in which the data are read from the memory stage.

## Revendications

1. Récepteur radio, en particulier récepteur OUC avec:
- un étage de réception pour recevoir et démoduler un signal radio,
- un étage d'évaluation pour évaluer la qualité de réception des signaux radio reçus en fonction de critères de réception préalablement déterminés,
- un étage de mémoire pour enregistrer des données sur au moins des fréquences d'émission et/ou des noms d'émetteurs dont les signaux radio répondent aux critères de réception préalablement déterminés;
- un élément de commande pour régler l'étage de réception sur la réception du signal radio d'un émetteur souhaité,
- un élément d'affichage pour afficher une information dérivée des données enregistrées sur au moins l'émetteur souhaité et
- une unité de commande pour commander au moins l'étage de réception, l'étage de mémoire et l'élément d'affichage en fonction de l'actionnement de l'élément de commande et de la qualité de réception évaluée par l'étage d'évaluation,
**caractérisé en ce que**, pour le réglage de l'étage récepteur sur les émetteurs souhaités, les données des émetteurs dont les signaux radio répondent aux critères de réception préalablement déterminés peuvent être lues dans un ordre déterminé par l'unité de commande et classées en fonction de caractéristiques sélectionnables par actionnement de l'élément de commande à partir de l'étage de mémoire, l'élément de commande étant conçu avec un seul organe sélecteur par lequel il est possible de passer d'un émetteur souhaité à l'émetteur précédent ou suivant respectif dans l'ordre déterminé et que les données enregistrées dans l'étage de mémoire sont actualisées, du moins en partie, à l'une des conditions suivantes au choix en données des émetteurs dont les signaux radio remplissent à ce moment les critères de réception préalablement déterminés:
- lorsque la qualité de réception du signal radio d'un émetteur souhaité ne remplit pas ou plus pour le moment les critères de réception préalablement déterminés, les données correspondantes sont effacées dans l'étage de mémoire et l'étage de réception est réglé sur la réception du signal radio d'un nouvel émetteur souhaité; de préférence, le nouvel émetteur souhaité présente le même programme que l'émetteur souhaité jusqu'à présent et les données du nouvel émetteur souhaité remplacent dans l'étage de mémoire les données effacées de l'émetteur souhaité jusqu'à présent; de préférence, le nouvel émetteur souhaité est en particulier trouvé par une recherche d'émetteur de l'étage de réception;
- lorsque l'émetteur souhaité est modifié par l'actionnement de l'élément de commande, on vérifie si le signal radio du nouvel émetteur souhaité remplit les critères de réception préalablement déterminés; si c'est le cas, les données sont complétées dans l'étage de mémoire par l'unité de commande des données du nouvel émetteur souhaité; de préférence, la fréquence d'émission du nouvel émetteur souhaité est trouvée en l'occurrence par une recherche d'émetteur de l'étage de réception;
- avant que l'étage de réception du récepteur radio soit au moins désactivé, les données des émetteurs dont les signaux radio répondent aux critères de réception préalablement déterminés sont réenregistrées dans l'étage de mémoire par l'unité de commande par une recherche d'émetteur pour une plage de fréquence d'émission la plus vaste possible, de préférence pour toutes les fréquences d'émission sur lesquelles l'étage de réception peut être réglé;
les données des émetteurs étant obtenues à partir d'une détermination des fréquences d'émission des signaux radio reçus et/ou d'un flux de données RDS reçu comme une partie des signaux radio.

2. Récepteur radio selon la revendication 1,
**caractérisé en ce que** l'étage d'évaluation et l'unité de commande au moins sont rassemblés dans un microprocesseur.

3. Récepteur radio selon la revendication 1,
**caractérisé en ce que** l'organe de sélection est conçu à la manière d'un bouton rotatif de sélection d'émetteur et que l'élément de commande comprend un capteur d'incréments couplé à l'organe de sélection pour passer à l'émetteur respectivement voisin dans l'ordre déterminé.

4. Récepteur radio selon la revendication 1,
**caractérisé en ce que** la fréquence d'émission est sélectionnée comme caractéristique de l'ordre déterminé pour la lecture des données de l'étage de mémoire.

5. Récepteur radio selon la revendication 1,
**caractérisé en ce que** les noms d'émetteurs, de préférence par ordre alphabétique, sont sélectionnés comme caractéristique pour la lecture des données de l'étage de mémoire.
